# EUROPEAN PATENT APPLICATION

(11) **EP 2 562 820 A1**
(43) Date of publication of application: **27.02.2013**
(21) Application number: 11772017.7
(22) Date of filing: 19.04.2011
(51) Int. Cl.: H01L 31/04, H01L 31/042

(54) **SOLAR CELL MODULE, AND PRODUCTION METHOD FOR SOLAR CELL MODULE**

(30) Priority: 19.04.2010 JP 2010095778
(71) Applicant: Sony Chemical & Information Device Corporation, Tokyo 141-0032 (JP)
(72) Inventor: OKUMIYA, Hideaki, Tokyo 141-0032 (JP); SUGA, Yasuhiro, Tokyo 141-0032 (JP)
(74) Representative: Müller - Hoffmann & Partner
(86) International application number: PCT/JP2011/059655
(87) International publication number: WO 2011/132682

(57) **Abstract**

Thermal pressing is performed at a low pressure to improve adhesive between an Al rear surface electrode formed on, especially, a rear surface of a solar battery cell and a conductive adhesive film while preventing the solar battery cell from being broken.

A solar battery module includes a plurality of silicon cell substrates (2) each having a front surface electrode (11) formed on a light-receiving surface and an Al rear surface electrode (13) formed on a rear surface opposite of the light-receiving surface, the front surface electrode (11) of one of the silicon cell substrates (2), a tab wire (3) that connects the front surface electrode (11) of one of the silicon cell substrates (2) to the Al rear surface electrode (13) of another silicon cell substrate (2) adjacent to the one of the silicon cell substrate (2), and a conductive adhesive agent layer (20) that connects the front surface electrode (11), and in the Al rear surface electrode (13), an opening (31) is formed in the Al rear surface electrode (13) at a connection portion (30) to the tab wire (3).

## Description

### Field of the Invention

The present invention relates to a solar battery module in which electrodes of a plurality of solar battery cells are connected with tab wires and a method of manufacturing a solar battery module.
The present application claims priority rights to JP Patent Application 2010-095778 filed in Japan on April 19, 2010, which is hereby incorporated by reference.

### Background of the Invention

In a crystal-silicon solar battery module, a plurality of adjacent solar battery cells are connected with a tab wire made of ribbon-like copper foil coated with solder. The tab wire has one end connected to a front surface electrode of one solar battery cell and the other end connected to a rear surface electrode of an adjacent solar battery cell to connect the solar battery cells in series with each other.

More specifically, in connection between a solar battery cell and a tab wire, a bus bar electrode formed by screen-printing silver paste on a light-receiving surface of the solar battery cell, an Ag electrode formed on a rear surface connection portion of the solar battery cell, and the tab wire are connected to each other by solder processing (Patent Document 1). An Al electrode is formed in a region except for the connection portion of the rear surface of the solar battery cell.

However, since a connection process is performed at a high temperature of about 260°C by soldering, the reliability of connection between the front surface electrode and the rear surface electrode of the solar battery cell and the tab wire may be deteriorated due to warpage of the solar battery cell, internal stress occurring in connection portions between the tab wire and the front and rear surface electrodes, a residual of flux, and the like.

Thus, in the past, in the connection between the front surface electrode and the rear surface electrode of the solar battery cell and the tab wire, a conductive adhesive film that can make a connection by a thermocompression process at a relatively low temperature is used (Patent Document 2). As the conductive adhesive film, a film formed such that spherical or ramentaceous conductive particles having an average particle diameter of several µ millimeter order are dispersed in a thermosetting binder resin composite is used.

### Prior-art Documents

### Patent Document

PTL 1: Japanese Patent Application Laid-Open No. 2004-356349
PTL 2: Japanese Patent Application Laid-Open No. 2008-135654

### Summary of the Invention

When a solar battery cell of the crystal-silicon solar battery module is connected by using a conductive adhesive film, the front surface of the solar battery cell configured by a silicon substrate and the conductive adhesive film are strongly bonded to each other. For this reason, the front surface electrode and the tab wire are connected without any problem. On the other hand, since the strength of the Al electrode itself formed on a region except for the connection portion on the cell rear surface is not high, the bonding strength between the solar battery cell and the tab wire is not very high.

Connection between the rear surface electrode on the cell rear surface and the tab wire is performed such that the tab wire is heated while applying a pressure of about 0.5 to 3 MPa to the rear surface electrode through the conductive adhesive film, and a weight of several hundred N is applied to one silicon substrate. In this case, in a crystal silicon solar battery cell, it is a problem to obtain a large amount of silicon serving as a raw material at low costs. In recent years, very thin (for example, 200 µm to 150 µm) silicon wafers begin to cut out of a polycrystalline silicon ingot and to be used in mass-production. Thus, the strength of the silicon substrate is not always high, and thermal pressing must be performed at a low pressure for breakage prevention.

However, in a conventional solar battery module, when thermal pressing is performed to a tab wire at a low pressure, the reliability of connection to an Ag electrode formed on connection portions of front and rear surfaces of a cell may be deteriorated.

The bonding strength of a conductive adhesive film to the Al electrode is not sufficient. The Al electrode can be formed in a region except for the connection portion on the rear surface of the solar battery cell, and an Ag electrode is formed on the connection portion to make it possible to improve the bonding strength between the Ag electrode and the conductive adhesive film. However, in the method of securing the reliability of connection between the tab wire and the rear surface electrode as described above, for the above reason, the Ag electrode must be formed on the connection portion, the number of parts, the an number of manufacturing steps, and cost are increased, and a large number of solar battery modules are difficult to be supplied at low costs.

Thus, it is an object of the present invention to provide a solar battery module in which adhesive properties between a rear surface electrode formed on a rear surface of a solar battery cell and a conductive adhesive film are improved while preventing the solar battery cell from being broken by performing thermal pressing at a low pressure and a method of manufacturing a solar battery module.

In order to solve the above problem, a solar battery module according to the present invention includes: a plurality of silicon cell substrates each having a front surface electrode formed on a light-receiving surface and an Al rear surface electrode formed on a rear surface opposite of the light-receiving surface; a tab wire that connects the front surface electrode of one of the silicon cell substrates to the Al rear surface electrode of another silicon cell substrate adjacent to the one of the silicon cell substrate; and a conductive adhesive agent layer that connects the front surface electrode, the Al rear surface electrode, and the tab wire, and an opening is formed in the Al rear surface electrode at a connection portion to the tab wire.

According to the present invention, a method of manufacturing a solar battery module in which, in one of a plurality of silicon cell substrates each having a front surface electrode formed on a light-receiving surface and an Al rear surface electrode formed on a rear surface opposite of the light-receiving surface, the front surface electrode and the Al rear surface electrode of another silicon cell substrate adjacent to the one of the silicon cell substrates are electrically connected to each other with a tab wire includes: the step of interposing a conductive adhesive film between the tab wire and the front surface electrode and the Al rear surface electrode; and the step of thermally pressing the tab wire to the front surface electrode and the Al rear surface electrode, and an opening is formed in the Al rear surface electrode at a connection portion to the tab wire.

### Effects of Invention

According to the present invention, since the opening is formed in the connection portion of the Al rear surface electrode to which the tab wire is connected, the conductive adhesive agent layer is directly connected to not only the Al rear surface electrode but also the front surface of the silicon cell substrate exposed to the opening. Furthermore, in the present invention, since the connection portion has the opening, a surface area of the Al rear surface electrode on the connection portion decreases, and a pressure to the Al rear surface electrode can be automatically increased even though a pressure applied to the connection portion except for the opening in the thermal pressing is a low pressure. Thus, in the invention of the present application, the tab wire can be strongly bonded to the connection portion of the Al rear surface electrode with the conductive adhesive agent layer even under a low pressure, and the reliability of connection can also be secured.

### Brief Description of the Drawings

Figure 1 is an exploded perspective view of a solar battery module to which the present invention is applied.
Figure 2 is a sectional view of a solar battery cell.
Figure 3 is a bottom view showing an Al rear surface electrode of a solar battery cell to which the present invention is applied.
Figure 4 is a bottom view showing an Al rear surface electrode of a solar battery cell to which a tab wire is connected and to which the present invention is applied.
Figure 5 is a bottom view showing an Al rear surface electrode of another solar battery cell to which a tab wire is connected and to which the present invention is applied.
Figures 6A and 6B are plan views showing a solar battery cell using a bus bar electrode having a notched portion.
Figure 7 is a sectional view showing a configuration of a conductive adhesive film.
Figure 8 is a diagram showing the conductive adhesive film.
Figure 9 is a diagram for explaining a configuration in which a tab wire obtained by giving a predetermined curvature to a connection surface is thermally pressed to an Al rear surface electrode through the conductive adhesive film.
Figure 10 is a diagram for explaining a configuration in which a tab wire is thermally pressed to a pressed surface with a thermally pressing head having a predetermined curvature.
Figure 11 is a diagram for explaining an experiment.
Figure 12 is a diagram for explaining a curvature given to a connection surface of a tab wire.
Figure 13 is a graph showing an experiment result.

### Detailed Description of the Invention

A solar battery module to which the present invention is applied and a method of manufacturing the same will be described below with reference to the drawings. A solar battery module 1 to which the present invention is applied is a crystal silicon solar battery module using a single-crystal silicon photoelectric conversion element or a polycrystalline photoelectric conversion element as a photoelectric conversion element or a thin-film silicon solar battery using a photoelectric conversion element obtained by stacking a cell made of amorphous silicon and a cell made of microcrystalline silicon or amorphous silicon-germanium.

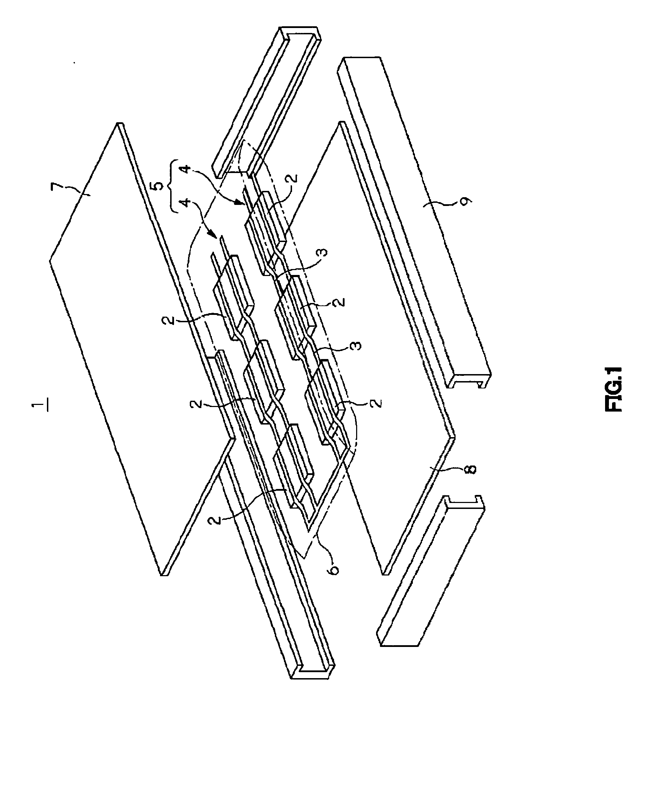

The solar battery module 1, as shown in Figure 1, has strings 4 to which a plurality of solar battery cells 2 are connected in series with each other with a tab wire 3 serving an inter-connector, and includes a matrix 5 obtained by arranging the plurality of strings 4. The solar battery module 1 is formed such that the matrix 5 is sandwiched with sheets 6 made of a sealing adhesive agent, integrally laminated together with a front surface cover 7 formed on a light-receiving surface and a back sheet 8 formed on a rear surface, and finally has a metal frame 9 made of aluminum or the like and attached therearound.

As a sealing adhesive agent, a transparent sealant such as an ethylene-vinylalcohol resin (EVA) is used. As a front surface cover, for example, a transparent material such as glass or transparent plastic is used. As the back sheet 8, a layered body or the like obtained by holding glass or aluminum foil between resin films is used.

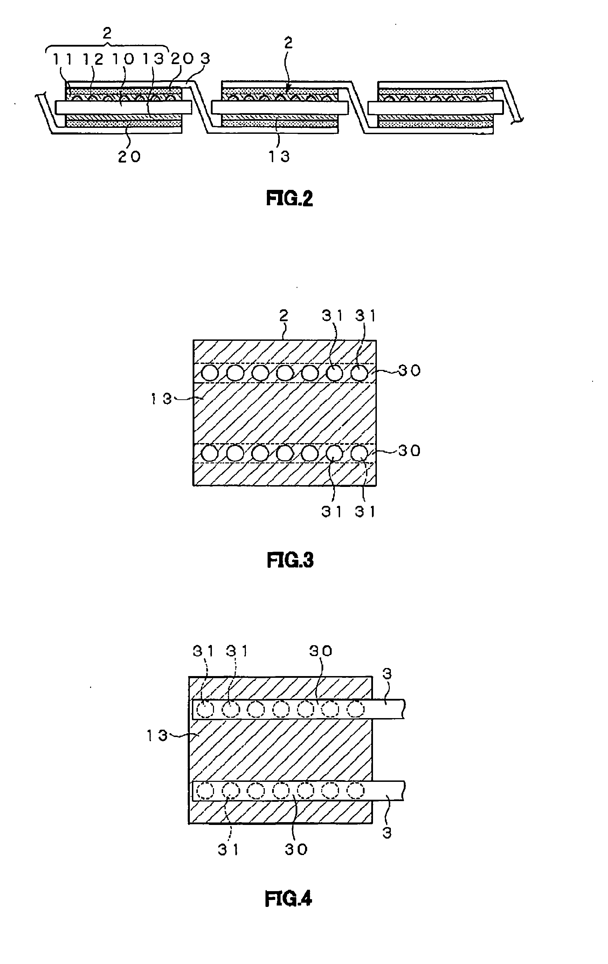

Each of the solar battery cells 2 of the solar battery module, as shown in Figure 2, has a photoelectric conversion element 10 made of a silicon substrate. On the light-receiving surface of the photoelectric conversion element 10, a bus bar electrode 11 serving as a front surface electrode and a finger electrode 12 serving as a collector electrode formed in a direction almost orthogonal to the bus bar electrode 11 are formed. On a rear surface of the photoelectric conversion element 10 opposite of the light-receiving surface, an Al rear surface electrode 13 made of aluminum is formed.

The bus bar electrode 11 on the front surface of each of the solar battery cells 2 is electrically connected to the Al rear surface electrode 13 of an adjacent solar battery cell 2 with the tab wire 3, thereby configuring the strings 4 connected in series with each other. Connection between the tab wire 3, the bus bar electrode 11, and the Al rear surface electrode 13 is performed with a conductive adhesive film 20.

The tab wire 3 can use a tab wire used in a conventional solar battery module. The tab wire 3 is formed such that, for example, ribbon-like copper foil having a thickness of 50 to 300 µm is used and subjected to gold plating, silver plating, tin plating, solder plating, or the like, as necessary.

The bus bar electrode 11 is formed by applying Ag paste and heating the Ag paste. The bus bar electrode 11 formed on the light-receiving surface of the solar battery cell 2 is formed in the form of a line having a width of, for example, 1 mm to reduce an area for shielding incident light to suppress a shadow loss. The number of bus bar electrodes 11 are arbitrarily set in consideration of the size or the resistance of the solar battery cell 2.

The finger electrodes 12 are formed over almost the entire area of the light-receiving surface of the solar battery cell 2 to cross the bus bar electrodes 11 by the same method as that for the bus bar electrodes 11. As the finger electrodes 12, lines each having a width of, for example, about 100 µm are formed at predetermined intervals of, for example, 2 mm.

As the Al rear surface electrode 13, as shown in Figure 3, an electrode made of aluminum is formed on the rear surface of the solar battery cell 2 by, for example, screen printing, sputtering, or the like. In the Al rear surface electrode 13, an opening 31 is formed in a connection portion 30 to the tab wire 3 to expose Si constituting the photoelectric conversion element 10 to the outside. Thus, the solar battery cell 2, as shown in Figure 4, the conductive adhesive film 20 is brought into contact with Si on the front surface of the photoelectric conversion element 10 through the opening 31 of the Al rear surface electrode 13. In this manner, the conductive adhesive film 20 can conduct electricity at an Al portion in connection between the tab wire 3 and the Al rear surface electrode 13, and can secure connection strength with an Si portion exposed through the opening 31.

In this manner, the solar battery cell 2 secures connection strength to the conductive adhesive film 20 by forming the opening 31 in the connection portion 30 between the Al rear surface electrode 13 and the tab wire 3. For this reason, the connection strength between the tab wire 3 and the Al rear surface electrode 13 is secured. The opening 31 is formed in the connection portion 30 to concentrate a pressure in application of pressure on the region of the connection portion 30 except for the opening 31. Thus, in the solar battery cell 2, even though a cell substrate is formed by using a very thin silicon wafer, by using the conductive adhesive film 20, the tab wire 3 can be connected to the Al rear surface electrode 13 by thermal pressing at a low pressure, and connection strength between the tab wire 3 and the Al rear surface electrode 13 can be secured without a risk of breaking a cell. In the solar battery cell 2, an Ag electrode need not be formed on the rear surface, and a low cost, a reduction in number of manufacturing steps, and the like can be achieved.

In the Al rear surface electrode 13, the connection portion 30 to which the tab wire 3 is connected with the conductive adhesive film 20 is secured in the form of a line, and a plurality of openings 31 are formed in the connection portion 30. The openings 31 are formed in the connection portion 30 at predetermined intervals. When the opening 31 has, for example, a circular shape having a diameter of 1, a distance between the adjacent openings 31 is set to about 0.5 to 5. In the Al rear surface electrodes 13, the plurality of openings 31 are formed in the connection portion 30 at predetermined intervals to bring the conductive adhesive film 20 into contact with Si on the front surface of the photoelectric conversion element 10 over the entire length of the connection portion 30 so as to make it possible to improve the connection strength. The shape of the opening 31 is not limited to a circular shape, and the shape of the opening can be arbitrarily designed to be a square shape or the like.

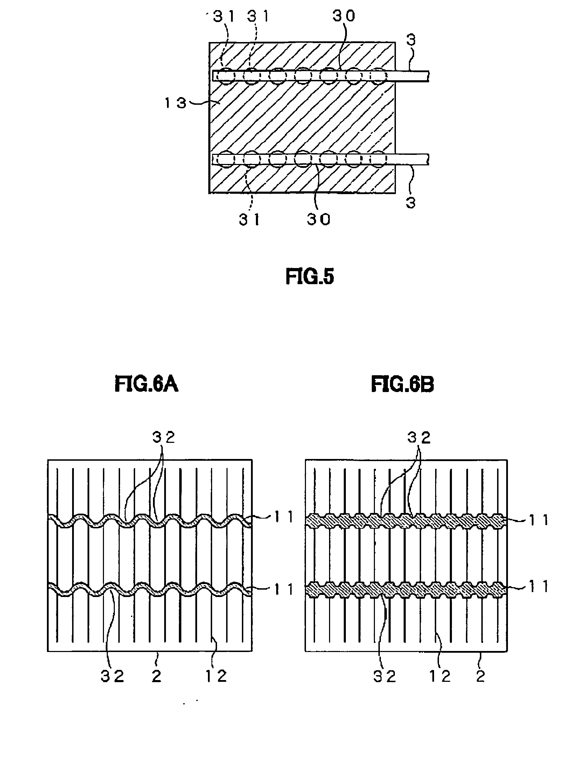

The opening 31, as shown in Figure 5, may be formed to have a diameter larger than the width of the tab wire 3. For example, when the opening 31 is formed in a circular shape, the opening 31 is formed to have a diameter larger than the width of the tab wire 3 by about 1.1 to 2.0 times. When the opening 31 is formed in a square shape, the opening 31 is formed to have a width larger than the line width of the tab wire 3 by about 1.1 to 2.0 times. In this manner, when the opening 31 is formed to be larger than the line width of the tab wire 3, a region to cause a resin of the conductive adhesive film 20 to escape when the tab wire 3 is thermally pressed to the Al rear surface electrode 13 is formed in the solar battery cell 2 to make it possible to prevent the resin from being protruded. Furthermore, the solar battery cell 2 can also tolerate displacement of the connection position of the tab wire 3.

An opening may be formed in the connection portion to the tab wire 3 formed on the front surface of the solar battery cell 2, thereby securing the connection strength at a low pressure in the same manner as described above. At this time, as shown in Figures 6A and 6B, when the bus bar electrode 11 has a notched portion 32, a pressure is concentrated in application of pressure. Similarly, the connection strength can be secured at a low pressure.

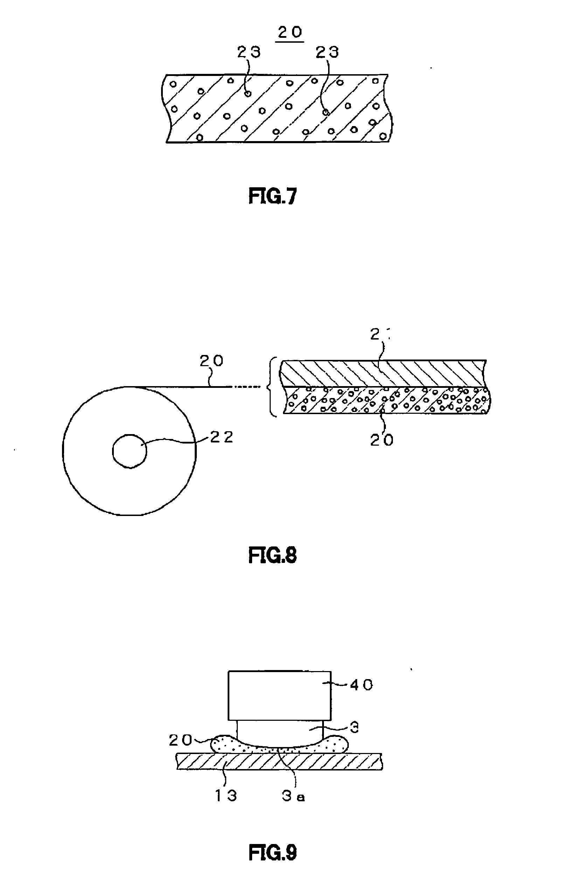

The conductive adhesive film 20, as shown in Figure 7, is a thermosetting binder resin layer containing conductive particles 23 at a high density.

In the conductive adhesive film 20, a minimum melt viscosity of a binder resin is preferably set to 100 to 100000 Pa·s in terms of push-fitting property. In the conductive adhesive film 20, when the minimum melt viscosity is excessive low, in the low thermocompression step to the main hardening step, the resin flows and easily protrudes to a defective connection portion or the light-receiving surface to cause deterioration of a light receiving rate. When the minimum melt viscosity is very high, a defect easily occurs when the film is stuck, and the reliability of connection may be adversely affected. The minimum melt viscosity can be measured such that a predetermined amount of sample is filled in a rotational viscometer while increasing a temperature at a predetermined temperature-rising rate.

The conductive particles 23 used in the conductive adhesive film 20 are not limited to specific particles. For example, metal particles made of nickel, gold, or copper or resin particles subjected to gold plating or the like, particles obtained by performing metal plating to resin particles and having insulating coating as outermost layers, or the like can be given. As the conductive particles 23, flat flake-like metal particles are contained to increase the number of overlapping conductive particles 23 so as to make it possible to secure preferable conduction reliability.

The conductive adhesive film 20 preferably has a viscosity of 10 to 10000 kPa·s at almost normal temperature, and, more preferably, 10 to 5000 kPa. Since the viscosity of the conductive adhesive film 20 falls within the range of 10 to 10000 kPa·s, when a conductive adhesive film is winded on a reel like a tape is used as the conductive adhesive film 20, so-called protruding can be prevented, and a predetermined tuck force can be maintained.

A composition of the binder resin layer of the conductive adhesive film 20 is not limited to a specific composition unless the characteristics described above are harmed. However, more preferably, the binder resin layer contains a film forming resin, a liquid epoxy resin, and a potential hardening agent, and a silane coupling agent.

The film forming resin corresponds to a high-molecular-weight resin having an average molecular weight of 10000 or more, and preferably has an average molecular weight of about 10000 to 80000 in terms of film forming ability. As the film forming resin, various resins such as an epoxy resin, a modified epoxy resin, a urethane resin, and a phenoxy resin can be used. Of these resins, the phenoxy resin is preferably used in terms of a film forming state, connection reliability, and the like.

The liquid epoxy resin is not limited to a specific one, and all commercially available epoxy resins having fluidity at normal temperature can be used. As the epoxy resin, more specifically, a naphthalene epoxy resin, a biphenyl epoxy resin, a phenolnovolac epoxy resin, a bisphenol epoxy resin, a stilbene epoxy resin, a tri-phenol methane epoxy resin, a phenol aralkyl epoxy resin, a naphthol epoxy resin, a dicyclopentadiene epoxy resin, a tri-phenylmethane epoxy resin, and the like can be used. The resins may be independently used, and two or more of the resins may be used. Furthermore, the resins may be used by being arbitrarily combined to another organic resin such as a acrylate resin.

As the potential hardening agent, various hardening agents such as a heat setting hardening agent and a UV setting hardening agent can be used. The potential hardening agent does not react in a normal state, and is activated by some trigger to start a reaction. As the trigger, heat, light, pressure, or the like is known.
The triggers may be selected depending on applications and used. When a liquid epoxy resin is used, a potential hardening agent made of imidazoles, amines, sulfonium salt, onium salt, or the like can be used.

As the silane coupling agent, an epoxy-based silane coupling agent, an amino-based silane coupling agent, a mercaptal-sulfide-based silane coupling agent, a ureide silane coupling agent, or the like can be used. Of these agents, in the embodiment, the epoxy-based silane coupling agent is preferably used. In this manner, adhesive on an interface between an organic material and an inorganic material can be improved.

As another additive composition, an inorganic filler is preferably contained. When the inorganic filler is contained, the fluidity of the resin layer is adjusted in a thermocompression process, a particle trapping rate can be improved. As the inorganic filler, silica, talc, titanium oxide, calcium carbonate, magnesium oxide, or the like can be used. The type of the inorganic filler is not limited to a specific one.

Figure 8 is a diagram schematically showing an example of a product configuration of the conductive adhesive film 20. The conductive adhesive film 20 is formed such that a binder resin layer is laminated on a peeling base material 21 and shaped in the form of a tape. The tape-like conductive adhesive film is winded and laminated on a reel 22 such that the peeling base material 21 is on an outer peripheral side. The peeling base material 21 is not limited to a specific one, and PET (Poly Ethylene Terephthalate), OPP (Oriented Polypropylene), PMP (Poly-4-methlpentene-1), PTFE (Polytetrafluoroethylene), or the like can be used. The conductive adhesive film 20 may be configured to have a transparent cover film on the binder resin layer.

At this time, as the cover film stuck on the binder resin layer, the tab wire 3 described above may be used. In this manner, when the tab wire 3 and the conductive adhesive film 20 are integrally laminated in advance, in actual use, the peeling base material 21 is peeled, and the binder resin layer of the conductive adhesive film 20 is stuck onto the connection portion 30 of the bus bar electrode 11 or the Al rear surface electrode 13 to connect the tab wire 3 and the electrodes 11 and 13 to each other.

The conductive adhesive film 20 is not limited to a conductive adhesive film winded on a reel, and a strip-shaped conductive adhesive film may be used.

As shown in Figure 8, when the conductive adhesive film 20 is provided as a reel product on which a film is winded, the viscosity of the conductive adhesive film 20 is set in the range of 10 to 10000 kPa·s to prevent the conductive adhesive film 20 from being deformed so as to make it possible to maintain predetermined dimensions. When the two or more strip-like conductive adhesive films 20 are laminated, similarly, the conductive adhesive films 20 can be prevented from being deformed, and predetermined dimensions can be maintained.

For the conductive adhesive film 20 described above, the conductive particles 23, the film forming resin, the liquid epoxy resin, the potential hardening agent, and the silane coupling agent are solved in a solvent. As the solvent, toluene, acetic ether, or the like or a mixed solvent thereof can be used. A resin generating solution obtained by solving is applied onto the peeling sheet, and the solvent is vaporized to obtain the conductive adhesive film 20.

In the solar battery cell 2, an Ag paste is applied on the front surface of the photoelectric conversion element 10 and sintered to form the finger electrode 12 and the bus bar electrode 11. On the rear surface, the Al rear surface electrode 13 having the opening 31 formed in the connection portion 30 of the tab wire 3 is formed by Al screen printing or the like.

In the photoelectric conversion element 10, the conductive adhesive film 20 is stuck to the bus bar electrode 11 on the front surface and the connection portion 30 on the rear surface, and the tab wire 3 is arranged on the conductive adhesive film 20. The lamination of the conductive adhesive film 20 and the tab wire 3 may be performed such that a film obtained by forming the binder resin layer of the conductive adhesive film 20 on one surface of the tab wire 3 is transferred onto the bus bar electrode 11 and the connection portion 30.

The tab wire 3 is thermally pressed from the upper side at a predetermined pressure, and the tab wire 3 is electrically connected to the bus bar electrode 11 and the Al rear surface electrode 13. At this time, the tab wire 3 is strongly mechanically connected to the bus bar electrode 11 because the binder resin of the conductive adhesive film 20 has preferable adhesive to the bus bar electrode 11 made of Ag paste. The tab wire 3 is strongly mechanically connected to the Al rear surface electrode 13 in the opening 31 because the binder resin of the conductive adhesive film 20 has preferable adhesive to Si exposed to the plurality of openings 31 formed in the connection portion 30 of the Al rear surface electrode 13, and the tab wire 3 is electrically connected to other Al portions. Furthermore, the tab wire 3 is also strongly connected to regions except for the openings 31 of the connection portion 30 even at a low pressure because a pressure in application of pressure is concentrated in the regions except for the openings 31 of the connection portion 30.

In the solar battery module, the tab wire 3 may be formed in a curved shape in advance, and connection to the bus bar electrode 11 and the Al rear surface electrode 13 may be performed by using the curved tab wire 3. In this case, the tab wire 3, as shown in Figure 9, is formed in the form of a circular arc to have a width-direction central portion protruding toward the conductive adhesive film 20 and the Al rear surface electrode 13 when viewed from a cross-section direction, and a curvature radius of a connection surface 3a to the Al rear surface electrode 13 is regulated to 20 mm or less.

In this manner, when the connection surface 3a has a curvature of 20 mm or less when viewed from a cross-section direction, on the tab wire 3, in thermally pressing state, the binder resin of the conductive adhesive film 20 is easily excluded from the flat tab wire to both the sides in the width direction, and the conductive particles 23 are easily contacted. Thus, in the solar battery cell 2, the tab wire 3 need not be pressed at a high pressure to exclude the binder resin in the width direction. Even though the tab wire 3 is pressed at a low pressure, conductivity can be improved, and low-pressure packaging can be realized.

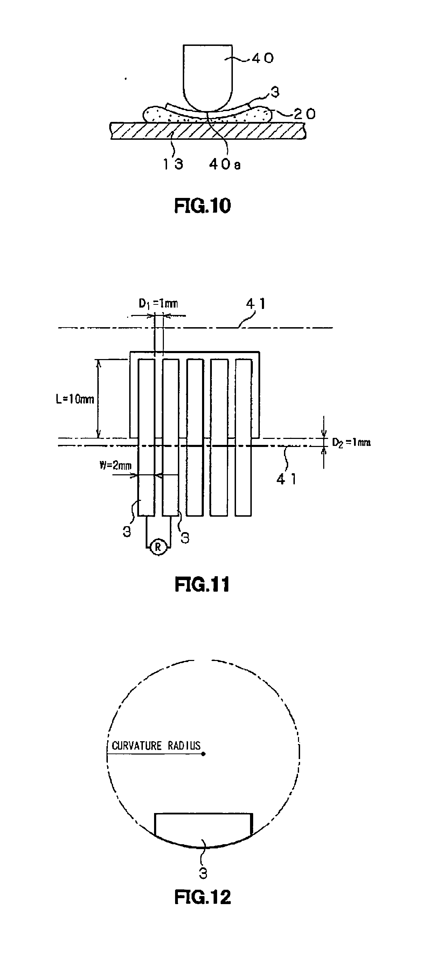

In addition to the curved tab wire 3, when the thickness of the tab wire 3 is sufficiently thin, a predetermined curvature is given to the distal end of a thermally pressing head, and, in thermally pressing state of the tab wire 3, the tab wire 3 may be formed to have a circular-arc section. More specifically, as shown in Figure 10, the distal end of a thermally pressing head 40 is formed such that the central portion in the width direction has a circular-arc shape protruding toward the conductive adhesive film 20 and the Al rear surface electrode 13 when viewed from the section side of the tab wire 3, and a pressing surface 40a has a curvature radius of 20 mm or less.

The thermally pressing head 40 thermally presses the tab wire 3 to exclude the binder resin of the conductive adhesive film 20 in the width direction through the tab wire 3. Thus, the tab wire 3 can improve conductivity to the Al rear surface electrode 13.

### <Experiment>

An experiment obtained by measuring conductivities of a sectionally flat tab wire and a tab wire in which a central portion in a width direction when viewed from a sectional direction projects toward the conductive adhesive film 20 and the Al rear surface electrode 13 has a circular-arc shape protruding and in which a curvature radius of the connection surface 3a is 20 mm or less will be described below.

In the experiment, as shown in Figure 11, the tab wire 3 was thermally pressed to a base material 41 (14 mm x 32 mm and a thickness of 2.8 mm) obtained by applying Ag paste to glass and sintered at a high temperature through a conductive adhesive film, and a resistance was checked. In each of the tab wires 3, a width W was 2 mm, and a sticking length L onto the base material 41 was 10 mm. A distance D₁ between adjacent tab wires was 1 mm. A distance D₂ between the base materials 41 was 1 mm. As the resistance, a resistance obtained by applying 1 A across adjacent tab wires was measured.

As the conductive adhesive film 20, a composition of matter containing 50 wt% of a solid material was coordinated such that 30 wt% of HX3941HP (available from Asahi Kasei Corporation) serving as a potential hardening agent, 30 wt% of Epicoat 828 (available from Japan Epoxy Resins Co.,Ltd.) serving as an epoxy resin, 30 wt% of YP-50 (available from Totokasei Co.,Ltd.) serving as a phenoxy resin, and 10 wt% of conductive particles including 50 wt% or more of ramentaceous Ni particles (Mohs hardness: 3.8) each having a longitudinal diameter of 1 to 20 µm, a thickness of 3 µm or less, and aspect ration of 3 to 50 were mixed with toluene to product a composition of matter including 50 wt% of solid material. The composition of matter was applied onto a peeling PET subjected to a peeling process by using a bar coater and dried for 5 minutes in an oven at 80°C to obtain the conductive adhesive film 20 having a thickness of 25 µm.

In connection between the tab wire 3 and an AG surface of the base material 41, pressure bonding was performed while changing pressing conditions from 0.5 MPa to 3.0 MPa in a heating condition, i.e., at 180°C for 15 sec. every 0.5 Mpa to measure resistances.

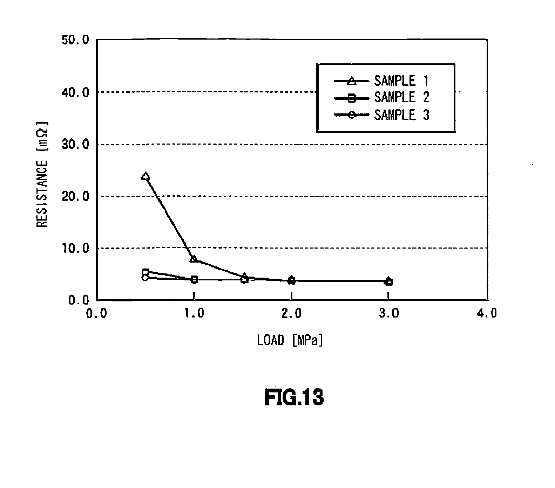

Under the above conditions, resistances of a sample (sample 1) having the tab wire 3 having a flat sectional shape, a sample (sample 2) having a curvature radius of 16 mm, and a sample (sample 3) having a curvature radius of 8 mm were measured. The curvature radius, as shown in Figure 12, means a curvature radius of the adhesive surface 3a obtained when a central portion in a width direction when viewed from the section of the tab wire 3 protrudes toward the conductive adhesive film 20 and the Al rear surface electrode 13. Measurement results are shown in Figure 13.

As shown in Figure 13, in the sample 1, a high resistance is obtained at a low load (0.5 MPa). In order to secure connection reliability, a load of 1.5 MPa or more is required. On the other hand, in the sample 2 and sample 3, a low resistance can be obtained at a low load (0.5 to 1.0 MPa), and no problem occurs in the connection reliability.

As described above, the central portion in the width direction is formed in a circular-arc shape protrude toward conductive adhesive film 20 and the Al rear surface electrode 13 when viewed from the section of the tab wire 3, and the curvature radius is 20 mm or less. In this case, even though the tab wire 3 is pressed at a low pressure, it is understood that sufficient connection reliability can be secured.

The present invention, in addition to the use of the conductive adhesive film 20, the tab wire 3 may be connected to the electrodes 11 and 13 by applying a paste conductive adhesive agent. In this case, as a melt viscosity, a viscosity at 25°C measured with a cone-and-plate viscometer is preferably 50 to 200 Pa·s, and, more preferably, 50 to 150 Pa·s.

In addition to the configuration in which the connection surface 3a of the tab wire 3 is formed as a curved surface having a curvature radius of 20 mm or less, as described above, when the predetermined opening is formed in the connection portion 30 of the Al rear surface electrode 13, the conductive adhesive film 20 and the silicon cell substrate surface of the solar battery cell 2 have preferable adhesive. For this reason, even though the tab wire 3 is thermally pressed at a low pressure, the tab wire 3 can be more strongly connected to the Al rear surface electrode 13.

In the solar battery cell 2, the bus bar electrode 11 is not always arranged. In this case, in the solar battery cell 2, a current of the finger electrode 12 is collected with the tab wire 3 crossing the finger electrode 12.

### Reference Signs List

1...Solar battery module, 2...Solar battery cell, 3...Tab wire, 4...Strings, 5...Matrix, 6...Sheet, 7...Front surface cover, 8...Back sheet, 9...Metal frame, 10...Photoelectric conversion element, 11...Bus bar electrode, 12...Finger electrode, 13...Al rear surface electrode, 20...Conductive adhesive film, 21...Peeling base material, 22...Reel, 30...Connection portion, 31...Opening, 40...Thermally pressing head

## Claims

1. A solar battery module comprising:
a plurality of silicon cell substrates each having a front surface electrode formed on a light-receiving surface and an Al rear surface electrode formed on a rear surface opposite of the light-receiving surface;
a tab wire that connects the front surface electrode of one of the silicon cell substrates to the Al rear surface electrode of another silicon cell substrate adjacent to the one of the silicon cell substrate; and
a conductive adhesive agent layer that connects the front surface electrode or the Al rear surface electrode to the tab wire, wherein
an opening is formed in the Al rear surface electrode at a connection portion to the tab wire.

2. The solar battery module according to claim 1, wherein
the conductive adhesive agent layer is bonded to a silicon surface of the silicon cell substrate exposed through the opening.

3. The solar battery module according to claim 1 or 2, wherein
the front surface electrode has a plurality of finger electrodes formed in parallel to each other on the light-receiving surface and a bus bar electrode crossing the plurality of finger electrodes, and
the tab wire is connected to the bus bar electrode formed on the light-receiving surface of the silicon substrate.

4. The solar battery module according to any one of claims 1 to 3, wherein
in the tab wire, a connection surface between the tab wire and the Al rear surface electrode has a curvature radius of 20 mm or less.

5. The solar battery module according to any one of claims 1 to 4, wherein
the opening has a diameter or a width larger than the width of the tab wire.

6. The solar battery module according to any one of claims 1 to 5, wherein
the opening is also formed in the connection portion to the tab wire on the front surface electrode.

7. The solar battery module according to any one of claims 1 to 6, wherein a notched portion is formed in the bus bar electrode that is formed on the silicon cell substrate and to which the tab wire is stuck.

8. A method of manufacturing a solar battery module in which, in one of a plurality of silicon cell substrates each having a front surface electrode formed on a light-receiving surface and an Al rear surface electrode formed on a rear surface opposite of the light-receiving surface, the front surface electrode and the Al rear surface electrode of another silicon cell substrate adjacent to the one of the silicon cell substrates are electrically connected to each other with a tab wire comprising:
the step of interposing a conductive adhesive film between the tab wire and the front surface electrode or the Al rear surface electrode; and
the step of thermally pressing the tab wire to the front surface electrode and the Al rear surface electrode, and
an opening is formed in the Al rear surface electrode at a connection portion to the tab wire.

9. The method of manufacturing a solar battery module according to claim 8, wherein
the conductive adhesive agent layer is bonded to a silicon surface of the silicon cell substrate exposed through the opening.

10. The method of manufacturing a solar battery module according to claim 8 or 9, wherein
the front surface electrode has a plurality of finger electrodes formed in parallel to each other on the light-receiving surface and a bus bar electrode crossing the plurality of finger electrodes, and
the tab wire is connected to the bus bar electrode formed on the light-receiving surface of the silicon substrate.

11. The method of manufacturing a solar battery module according to any one of claims 8 to 10, wherein
in the tab wire, a connection surface between the tab wire and the Al rear surface electrode has a curvature radius of 20 mm or less.

12. The method of manufacturing a solar battery module according to any one of claims 8 to 11, wherein
a pressing surface of a heater head that thermally presses the tab line has a curvature radius of 20 mm or less.

13. The method of manufacturing a solar battery module according to any one of claims 8 to 12, wherein
the opening has a diameter or a width larger than the width of the tab wire.

14. The method of manufacturing a solar battery module according to any one of claims 8 to 13, wherein
the opening is also formed in the connection portion to the tab wire on the front surface electrode.

15. The method of manufacturing a solar battery module according to any one of claims 8 to 14, wherein a notched portion is formed in the bus bar electrode that is formed on the silicon cell substrate and to which the tab wire is stuck.
